# EUROPÄISCHE PATENTSCHRIFT

(11) **EP 0 693 720 B1**
(45) Veröffentlichungstag und Bekanntmachung des Hinweises auf die Patenterteilung: **11.11.1998**
(21) Anmeldenummer: 95110906.5
(22) Anmeldetag: 12.07.1995
(51) Int. Cl.: G05B 19/042, H03M 1/28, H03M 7/20

(54) **Hybrid-Programmsteuereinrichtung, insbesondere für Haushaltsmaschinen**
Hybrid program control means, in particular for domestic appliances
Dispositif de commande à programme hybride en particulier pour des appareils ménagers

(30) Priorität: 21.07.1994 DE 4425758
(43) Veröffentlichungstag der Anmeldung: 24.01.1996
(73) Patentinhaber: AKO-Werke GmbH & Co. KG, 88239 Wangen im Allgäu (DE)
(72) Erfinder: Siebachmeyer, Fritz, Dipl.-Ing. (FH), D-88099 Neukirch (DE)
(74) Vertreter: Gaiser, Hartmut, Dipl.-Ing.

(56) Entgegenhaltungen:
- DE-A- 2 558 170
- US-A- 4 468 600
- US-A- 4 498 177

## Beschreibung

Die Erfindung betrifft eine Hybrid-Programmsteuereinrichtung, insbesondere für Haushaltsmaschinen, wie Waschmaschine, Wäschetrockner oder Spülmaschine, mit einem elektromechanischen Programmschaltwerk, bei dem von einem Timermotor angetriebene Nockenscheiben Schaltkontakte steuern, und mit einer Steuerelektronik, an die eine Gruppe der Schaltkontakte kodierte Programmsteuerbefehle legt.

In der DE 20 40 464 C2 ist ein elektromechanisches Programmschaltwerk für Haushaltsmaschinen beschrieben. Ein Timermotor treibt über ein Schrittschaltwerk Nockenscheiben einer Programmtrommel an. Solche Programmschaltwerke sind in der Weise weiterentwickelt, daß ein Teil der Funktionen auf eine Steuerelektronik, die beispielsweise mit einem Mikroprozessor arbeitet, übertragen sind. Ein solches Hybrid-Schaltwerk ist beispielsweise in der DE-OS 25 58 170 und der DE-OS 33 03 992 beschrieben.

An der Schnittstelle zwischen Programmschaltwerk und Steuerelektronik können die im jeweiligen Programmschritt vorgesehenen Steuerbefehle kodiert an die Steuerelektronik übertragen werden. Treten in der Übertragung der kodierten Signale Fehler auf, dann kann es zu Fehlfunktionen kommen.

In dem Fachbuch Hans Jörg Tafel "Einführung in die digitale Datenverarbeitung", Carl Hanser Verlag, München 1971, S. 29 bis 31 ist ein m aus n-Code beschrieben. Beispielsweise ist ein 2 aus 5-Code dargestellt, bei dem bei fünf Binärstellen eines Datenworts jeweils zwei logische Einsen auftreten.

Aufgabe der Erfindung ist es, eine Hybrid-Programmsteuereinrichtung der eingangs genannten Art vorzuschlagen, bei der durch den Ablauf des Programmschaltwerks (Schaltzustandsübergang) entstehende scheinbare Fehler und wirkliche Fehler, die zu einer Funktionsstörung führen, unterscheidbar sind, um eine einfache und sichere Schritt ausführung des Programmschaltwerke zu ermöglichen.

Erfindungsgemäß ist obige Aufgabe dadurch gelöst, daß die Steuerbefehle wenigstens teilweise in einem m aus n-Code kodiert sind, daß die Steuerelektronik den von ihr empfangenen Steuerbefehl auf die Summe der logischen Einsen prüft und daß die Steuerelektronik beim Auftreten von mehr oder weniger als m logischen Einsen andere Steuerfunktionen auslöst als beim Auftreten von m logischen Einsen.

Solange die Steuerelektronik in jedem nach einem m aus n-Code kodierten Steuerbefehl m Einsen summiert, ist dies ein Zeichen dafür, daß der Steuerbefehl und dessen Übertragung fehlerfrei ist. Die Steuerelektronik arbeitet diesen Programmschritt entsprechend ab.

Aufgrund der an den Nockenscheiben notwendigen Schaltschrägen kommt es beim Schaltzustandsübergang von einem Befehl auf den anderen Steuerbefehl oder möglicherweise bei der manuellen Einstellung bzw. Verstellung der Programmtrommel des Programmschaltwerks dazu, daß an der Steuerelektronik mehr bzw. weniger als m logische Einsen auftreten (scheinbarer Fehler). Mehr als m logische Einsen treten bei a-Kontakten (Schließer) beim Schaltzustandsübergang auf; weniger als m logische Einsen treten beim Schaltzustandsübergang bei b-Kontakten (Öffner) auf.

Beispielsweise wenn die elektrische Kontaktierung an der Schnittstelle zwischen dem Programmschaltwerk und der Steuerelektronik an irgendeiner Stelle unterbrochen ist, erfaßt die Steuerelektronik bei a-Kontakten weniger als m logische Einsen in Steuerbefehl (wirkliche Fehler). Die Steuerelektronik unterscheidet zwischen diesen beiden Fehlerfällen und löst im einen Fall eine andere Funktion als im anderen Fall aus. Es ist damit erreicht, daß die kodierte Übertragung der Steuerbefehle auf Fehler geprüft ist und durch bauliche Eigenschaften des Programmschaltwerks auftretende scheinbare Fehler unterdrückt werden.

In bevorzugter Ausgestaltung der Erfindung läßt die Steuerelektronik beim Auftreten von mehr bzw. weniger als m logischen Einsen, was erfolgt, wenn einer oder mehrere Schaltkontakte von ihrem einen Schaltzustand in ihren anderen Schaltzustand übergehen oder bei einer manuellen Einstellung der Programmtrommel versehentlich in einen Schaltzustands-Übergangsbereich gestellt werden, das Programmschaltwerk weiterlaufen, bis der Schaltzustandsübergang beendet ist. Danach ist dann die Summe der logischen Einsen wieder m. Die scheinbaren Fehler führen also nicht zu einer Unterbrechung des normalen Programmablaufs. Vorteilhaft ist zugleich, daß eine manuelle Fehleinstellung der Programmtrommel nicht zu einer Betriebsstörung führt. In der Praxis erfolgt eine solche Fehleinstellung häufig dadurch, daß vom Benutzer die Programmtrommel so eingestellt wird, daß Schaltkontakte im Bereich eines Schaltzustandsübergangs stehen. Die Steuerelektronik erkennt diese Fehleinstellung und läßt das Programmschaltwerk bzw. die Programmtrommel dann so weit drehen, bis ein definierter Schaltzustand erreicht ist. Fehleinstellungen werden also von selbst korrigiert.

In Ausgestaltung der Erfindung läßt die Steuerelektronik beim Auftreten von weniger als m logischen Einsen - bei a-Kontakten - eine Fehlerroutine ablaufen. Diese kann vorzugsweise darin bestehen, daß die fehlerhafte Programmstelle wiederholt angefahren wird und bei einer Wiederholung des Fehlers der Programmablauf gestoppt wird und/oder ein Alarm ausgelöst wird.

Ein Ausführungsbeispiel der Erfindung ergibt sich aus der folgenden Beschreibung. In der Zeichnung zeigen:

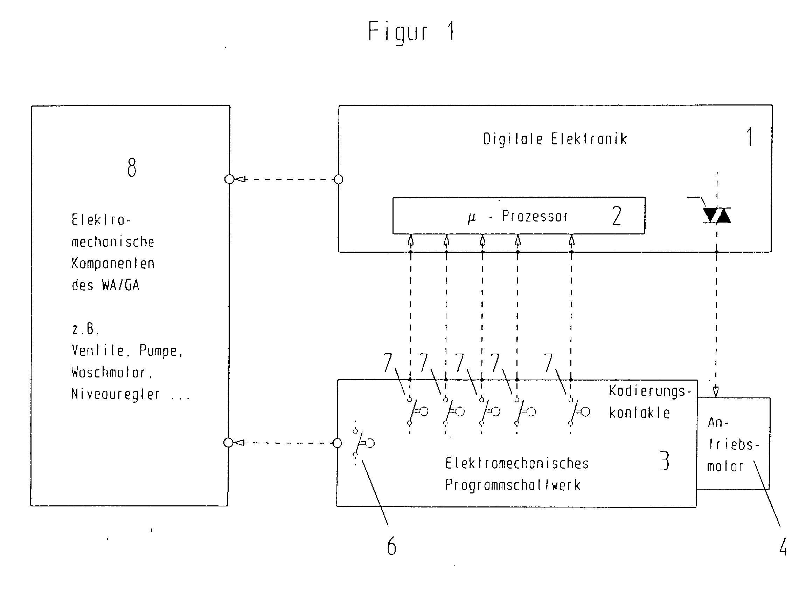

Figur 1 ein Blockschaltbild einer Hybrid-Programmsteuereinrichtung,
Figur 2a die Schaltverhalten eines a-Kontaktes (Schließers) in den Schrittübergangsbereichen,
Figur 2b die Schaltverhalten eines b-Kontaktes (Öffners) in den Schrittübergangsbereichen und
Figur 3 einen Programmausschnitt bei einer 2 aus 5-Kodierung und Verwendung von a-Kontakten als Ausführungsbeispiel.

Eine Hybrid-Programmsteuereinrichtung einer Wasch- oder Spülmaschine weist eine digitale Steuerelektronik(1) mit einem Mikroprozessor(2) sowie ein elektromechanisches Programmschaltwerk(3) mit einer manuell einstellbaren Programmtrommel auf. Ein Timermotor(4) ist zum Antrieb des Programmschaltwerks(3) vorgesehen und von der Steuerelektronik(1) gesteuert. Das Programmschaltwerk(3) weist übliche Nockenscheiben(5) auf, welche von dem Timermotor(4) angetrieben sind. Den Nockenscheiben(5) sind Betätigungskontakte(6) und Kodierungskontakte(7) zugeordnet. Beispielsweise sind bei einer 2 aus 5-Kodierung fünf Kodierungskontakte(7) und für diese fünf Nockenscheiben(5) vorgesehen. Die Kodierungskontakte(7) stehen mit dein Mikroprozessor(2) in Verbindung und rufen aus diesem in ihm gespeicherte Programmabläufe ab. Die Steuerelektronik(1) und/oder das Programmschaltwerk(3) schaltet Komponenten(8) der Maschine, beispielsweise Ventile, Pumpe, Waschmotor, Heizung, Niveauregler.

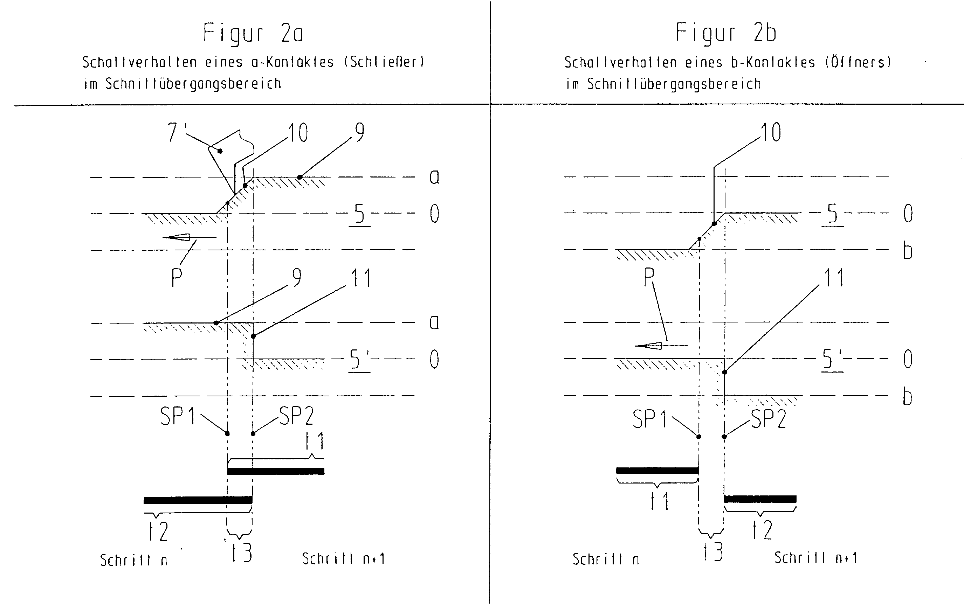

In Figur 2 sind Teilabwicklungen von Nockenscheiben(5,5') jeweils im Schrittübergangsbereich gezeigt. Der zugeordnete Schaltfinger(7'), mit dem der betreffende Kodierungskontakt(7) betätigt wird, ist nur an einer Stelle gezeigt. Die Nockenscheibe(5,5') werden in Richtung des Pfeiles(P) bewegt. Jede Nocke(9) weist eine ansteigende Schaltschräge(10) und eine steile Abfallflanke(11) für den zugeordneten Schaltfinger auf.

Im Falle der Figur 2a ist von a-Kontakten (Schließern) als Kodierungskontakten ausgegangen. Liegt der Schaltfinger(7') auf dem O-Niveau der Nockenscheibe(5,5'), dann ist der a-Kontakt geöffnet. Liegt der Schaltfinger (7') auf dem a-Niveau, dann ist der a-Kontakt geschlossen. Der a-Kontakt wird jeweils geschlossen, wenn der auf der Schaltschräge(10) liegende Schaltpunkt(SP1) unter dein Schaltfinger(7') hindurchgeht. Der a-Kontakt öffnet jeweils, wenn der Schaltpunkt(SP2) der Abfallflanke(11) unter dem Schaltfinger(7') hindurchgeht.

Bei der in Figur 2a gezeigten Stellung ergibt sich also, daß der der Nockenscheibe(5) zugeordnete a-Kontakt während der Zeit(t1) und der der Nockenscheibe(5') zugeordnete andere a-Kontakt während der Zeit(t2) eingeschaltet ist. Ersichtlich überlappen sich wegen der Schaltschräge(10) der Ein-Zustand der beiden a-Kontakte in der Übergangszeit(t3). Dies hat für die Auswertung der m aus n-Kodierung im Mikroprozessor zur Folge, daß von diesen beiden a-Kontakten in der Summe zwei logische Einsen (Einzustand entspricht logischer Eins) empfangen werden, obwohl imgrunde nur eine Umschaltung vorliegt.

Bei der Figur 2b liegen die Verhältnisse umgekehrt. Es ist von b-Kontakten als Kodierungskontakten ausgegangen. Liegt der Schaltfinger(7') auf dem O-Niveau der Nockenscheibe(5'), dann ist der b-Kontakt geöffnet. Liegt der Schaltfinger(7') auf dem b-Niveau, dann ist der b-Kontakt geschlossen. Der b-Kontakt wird jeweils geöffnet, wenn der auf der Schaltschräge(10) liegende Schaltpunkt(SP1) unter dem Schaltfinger(7') hindurchgeht. Der b-Kontakt wird jeweils geschlossen, wenn der Schaltpunkt(SP2) der Abfallflanke(11) unter dem Schaltfinger(7') hindurchgeht. Bei der in Figur 2b gezeigten Stellung ergibt sich also, daß der der Nockenscheibe(5) zugeordnete b-Kontakt wahrend der Zeit (t1) eingeschaltet ist und der der Nockenscheibe(5') zugeordnete andere b-Kontakt während der Zeit(t2) eingeschaltet ist. Ersichtlich überlappen sich hier wegen der Schaltschräge(10) die Einzustände der beiden b-Kontakte in der Übergangszeit(t3) nicht. Dies hat für die Auswertung der m aus n-Kodierung im Mikroprozessor zur Folge, daß von diesen beiden b-Kontakten in der Summe in der Übergangszeit(t3) keine logische Eins empfangen wird, obwohl imgrunde nur eine Umschaltung vorliegt.

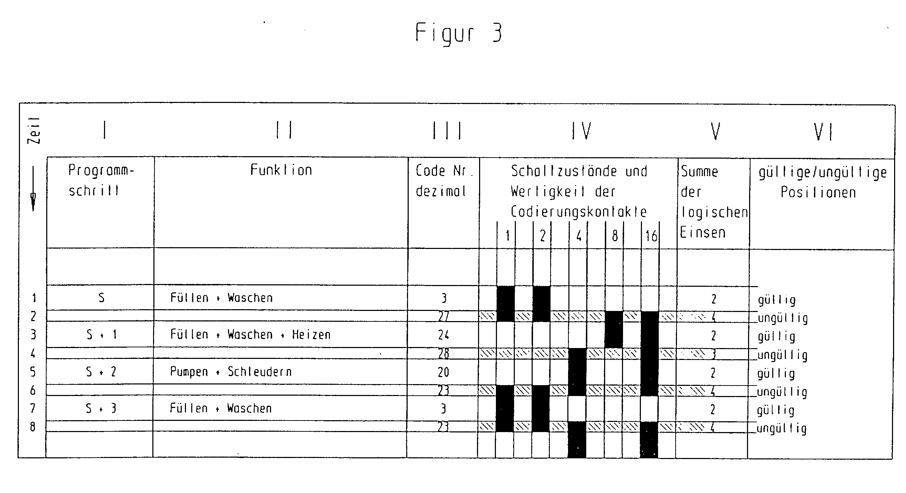

In Figur 3 ist ein möglicher Funktionsablauf für a-Kontakte dargestellt. Die Vorgänge laufen entsprechend der Zeitzeilen 1 bis 8 nacheinander ab.

In Spalte I ist gezeigt, daß in den Zeitzeilen 1,3,5,7 Programmschritte s, s+1, s+2, s+3 ablaufen, wobei in Spalte II die möglichen zugeordneten Funktionen eines Waschmaschinenprogramms angegeben sind. Die Zeitzeilen 2, 4,6,8 entsprechen den Schaltzustandsübergängen (Zeit t3 in Fig. 2a).

Spalte III gibt den Dezimalwert der Schaltzustände der Kodierungskontakte(7) in der 2 aus 5-Kodierung nach Spalte IV an.

Spalte IV zeigt geschwärzt die Ein-Zustände (logische Einsen) der fünf Kodierungskontakte(7), denen binäre Wertigkeiten 1,2,4,8,16 zugeordnet sind. Schraffiert sind die Schaltzustandsübergangsbereiche angedeutet.

In Spalte V sind die Summen der logischen Einsen, die sich aus den Schaltzuständen nach Spalte IV am Mikroprozessor(2) im zeitlichen Ablauf ergeben, dargestellt.

Spalte VI zeigt die aufgrund der 2 aus 5-Kodierung vom Mikroprozessor vorgenommen Bewertung der Summen.

Ersichtlich ist in der Zeitzeile 1 die Summe der logischen Einsen "2". Der Mikroprozessor erkennt daraus, daß kein Fehler vorliegt und arbeitet den Programmschritt s entsprechend ab. Danach steuert die Steuerelektronik(1) den Timermotor(4) so an, daß die Nockenscheiben(5) des Programmschaltwerks(3) um einen Programmschritt weitergeschaltet werden. Dabei kommt es im Übergangsbereich(t3) (vgl. Fig. 2a), d.h. in der Zeitzeile 2 dazu, daß die beiden Kodierungskontakte der Wertigkeiten 1 und 2 noch eingeschaltet sind und die Kodierungskontakte der Wertigkeiten(8 und 16) schon eingeschaltet sind, so daß der Mikroprozessor(2) als Summe der logischen Einsen "4" und 4 > 2 erkennt. Er läßt in diesem Falle den Timermotor(4) wenigstens für eine Zeit weiterlaufen, bis im Regelfalle die Schaltschrittübergänge(t3) erledigt sind. Dies geschieht auch, wenn das Programmschaltwerk manuell auf einen Schaltzustands-Übergangsbereich fehleingestellt wird. Danach ist dann - vgl. Zeitzeile 3 - wieder die Summe "2" der logischen Einsen erreicht. Entsprechendes ergibt sich bei dem weiteren Ablauf der Programmschritte bei Betrachtung der Zeitzeilen 4 bis 8.

Wird nach einer regelmäßigen Schaltschrittübergangszeit die Summe "2" nicht wieder erreicht, kann vorgesehen sein, daß der Mikroprozessor(2) den Programmablauf unterbricht und/oder andere Kontroll- oder Sicherheitsfunktion einschaltet.

Tritt eine Summe der logischen Einsen kleiner m, im Beispielsfall kleiner 2 auf, was beispielsweise der Fall sein kann, wenn eine der Verbindungsleitungen, in denen der betreffende Kodierungskontakt(7) liegt, unterbrochen ist, dann erfaßt der Mikroprozessor(2) dies ebenfalls und kann daraufhin den Programmablauf unterbrechen und eine Fehlerroutine oder Alarmierung einschalten.

Ähnlich wie anhand von Figur 3 beschrieben, liegen die Verhältnisse bei der Verwendung von b-Kontakten (vgl. Fig. 2b). In diesem Fall treten jedoch in den Schaltschrittübergangszeiten(t3) nicht mehr als m, sondern weniger als m logische Einsen auf. Dies kann der Mikroprozessor(2) in entsprechender Weise auswerten.

Mit der für den Beispielsfall angenommenen 2 aus 5-Kodierung mit der beschriebenen Fehlererkennung sind 10 Kodierungsmöglichkeiten verwertbar. Figur 3 zeigt nur drei dieser möglichen verwertbaren Kodierungen, wobei in den Zeitzeilen 1,3 und 5 unterschiedliche Kodierungen und in der Zeitzeile 7 die gleiche Kodierung wie in der Zeitzeile 1 gezeigt ist.

In anderen Fällen, wenn für die Kodierung der Programmschritte mehr Möglichkeiten erforderlich sind, kann mit einer anderen m aus n-Kodierung gearbeitet werden. Beispielsweise kann eine 4 aus 8-Kodierung vorgesehen sein. Es sind dann acht Nockenscheiben(5) acht Kodierungskontakte(7) zugeordnet, wobei sich theoretisch 256 Kodiermöglichkeiten ergeben, von denen jedoch nur 70 ausgenutzt werden, weil nur bei diesen die Summe der logischen Einsen "4" ist.

Es ist nicht erforderlich, daß für die Fehlererkennung alle Kodierungskontakte(7) verwendet werden. Es kann auch genügen, die Fehlererkennung nur für einen Teil der Kodierungskontakte zu verwenden. Es lassen sich dadurch Kodierungskontakte einsparen. Hierzu folgendes:

Sollen - entsprechend der auf dem Umfang der Programmtrommel gewöhnlich vorgesehenen 60 Schaltschritten - 60 Kodiermöglichkeiten vorgesehen sein, dann würde hierfür eine 4 aus 8-Kodierung benötigt. Es müßten also 8 Kodierungskontakte vorgesehen sein. Statt dessen wird eine 3 aus 6-Kodierung verwendet, die mit 6 Kodierungskontakten 20 Kodiermöglichkeiten ergibt. Zusätzlich wird ein Umschaltkontakt verwendet, der drei Schaltzustände, nämlich "a-ein", "b-ein" und "alles aus" einnehmen kann. Damit sind 60 Kodiermöglichkeiten gegeben. Die dem Umschaltkontakt zugeordnete Nockenscheibe wird so gestaltet, daß auf der Programmtrommel nacheinander 20 Schaltschritte für den Zustand "a-ein", darauf folgend 20 Schaltschritte für den Zustand "alles aus" und anschließend 20 Schaltschritte für den Zustand "b-ein" bestehen. Es lassen sich also mit nur 7 Kontakten 60 Kodiermöglichkeiten erreichen. Allerdings ist dabei in Kauf genommen, daß der Umschaltkontakt selbst nicht der Fehlererkennung unterliegt.

## Patentansprüche

1. Hybrid-Programmsteuereinrichtung, insbesondere für Haushaltsmaschinen, wie Waschmaschine, Wäschetrockner oder Geschirrspülmaschine, mit einem elektromechanischen Programmschaltwerk, bei dem von einem Timermotor angetriebene Nockenscheiben Schaltkontakte und Kodierungskontakte steuern, und mit einer Steuerelektronik, an die die Kodierungskontakte kodierte Programmsteuerbefehle legen,
dadurch gekennzeichnet,
daß die Steuerbefehle wenigstens teilweise in einem m aus n-Code kodiert sind, daß die Steuerelektronik(2) Mittel aufweist, die den von ihr empfangenen Steuerbefehl auf die Summe der logischen Einsen prüfen, und daß die Steuerelektronik(2) beim Auftreten von mehr oder weniger als m logischen Einsen andere Steuerfunktionen auslöst als beim Auftreten von m logischen Einsen, wobei die Steuerelektronik(2) beim Auftreten von mehr bzw. weniger als m logischen Einsen, was erfolgt, wenn einer oder mehrere Kodierungskontakte(7) von ihrem einen Schaltzustand in ihren anderen Schaltzustand übergehen oder in einen Schaltzustands-Übergangsbereich gestellt werden, das Programmschaltwerk weiterlaufen läßt, bis der Schaltzustandsübergang beendet ist.

2. Programmsteuereinrichtung nach Anspruch 1,
dadurch gekennzeichnet,
daß die Steuerelektronik(2) bei Verwendung von Schließerkontakten beim Auftreten von weniger als m logischen Einsen oder bei Verwendung von Öffnerkontakten beim Auftreten von mehr als m logischen Einsen eine Fehlerroutine ablaufen läßt.

3. Programmsteuereinrichtung nach Anspruch 2,
dadurch gekennzeichnet,
daß die Steuerelektronik(2) in der Fehlerroutine die fehlerhafte Programmstelle wiederholt anfährt und bei einer Wiederholung des Fehlers den Programmablauf stoppt und/ oder einen Alarm auslöst.

4. Programmsteuereinrichtung nach einem der vorhergehenden Ansprüche,
dadurch gekennzeichnet,
daß die Kodierungskontakte (7) Schließerkontakte sind.

## Claims

1. Hybrid programme control device, in particular for domestic machines such as washing machine, tumble dryer or dishwasher, having an electromechanical programme switchgear, in which cam discs driven by a timer motor control switch contacts and coding contacts, and having an electronic control device to which the coding contacts send coded programme control commands, characterised in that the control commands are coded at least in part in an m from n code, in that the electronic control device (2) has means which test the control command received from the electronic control device for the sum of the logical ones, and in that the electronic control device (2), upon the occurrence of logical ones of more or less than m triggers other control functions than at the occurrence of m logical ones, in which case the electronic control device (2), upon the occurrence of logical ones more or less than m, which happens if one or more coding contacts (7) move from their one switching state into their other switching state or are set in a switching state transition region, which allows the programme switchgear to continue running until the switching state transition is complete.

2. Programme control device according to claim I, characterised in that with the use of make contacts with the occurrence of logical ones less than m or with the use of break contacts with the occurrence of logical ones more than m, the electronic control device (2) allows an error routine to run.

3. Programme control device according to claim 2, characterised in that the electronic control device (2) repeatedly runs the faulty programme position in the fault routine and if the fault is repeated, slops the programme running and/or sets off an alarm.

4. Programme control device according to one of the preceding claims, characterised in that the coding contacts (7) are make contacts.

## Revendications

1. Dispositif de commande à programme hybride, notamment pour des appareils ménagers, comme le lave-linge, le sèche-linge ou le lave-vaisselle, avec un programmateur électromécanique, où des disques à cames entraînés par un moteur à horloge commandent des contacts de commutation et des contacts de codage, et avec une électronique de commande à laquelle les contacts de codage appliquent des instructions de commande de programme codées
caractérisé en ce que
les instructions de commande sont codées au moins partiellement en un code m résultant de n, en ce que l'électronique de commande (2) présente des moyens qui examinent l'instruction de commande reçue par celle-ci quant à la somme des uns logiques et en ce que l'électronique de commande (2) lors de la survenue de plus ou moins que m uns logiques déclenche d'autres fonctions de commande que lors de la survenue de m uns logiques, l'électronique de commande (2), lors de la survenue de plus respectivement moins que m uns logiques, ce qui a lieu lorsqu'un ou plusieurs contacts de codage (7) passent d'un état de commutation dans leur autre état de commutation ou sont placés dans une zone de transition d'états de commutation, permettant la continuation du programmateur jusqu'à ce que la transition de l'état de commutation soit terminée.

2. Dispositif de commande à programme selon la revendication 1,
caractérisé en ce que
l'électronique de commande (2), lors de l'utilisation de contacts de fermeture, lors de la survenue de moins que m uns logiques ou lors de l'utilisation de contacts d'ouverture, lors de la survenue de plus que m uns logiques permet le déroulement d'une routine d'erreur.

3. Dispositif de commande à programme selon la revendication 2,
caractérisé en ce que
l'électronique de commande (2) pendant la routine d'erreur aborde d'une manière répétée le lieu de programme incorrect et, lors d'une répétition de l'erreur, arrête le déroulement du programme et/ou déclenche une alarme.

4. Dispositif de commande à programme selon l'une des revendications précédentes,
caractérisé en ce que les contacts de codage (7) sont des contacts de fermeture.
